# EUROPEAN PATENT APPLICATION

(11) **EP 1 612 935 A1**
(43) Date of publication of application: **04.01.2006**
(21) Application number: 04102945.5
(22) Date of filing: 24.06.2004
(51) Int. Cl.: H03H 17/02, H03H 17/06, G06F 17/50

(54) **Signal Processing Component**

(71) Applicant: Renesas Technology Europe Limited, Bourne End, Bucks SL8 5FH (GB)
(72) Inventor: Tolson, Nigel, James, RG8 8BS, Reading (GB)
(74) Representative: Read, Matthew Charles

(57) **Abstract**

A signal processing component (28) for a digital receiver comprises a low pass filter (LPF) section (29) and a compensator (30). A plurality of shift registers (36) are provided in the LPF section (29) and arranged to act as power-of-two multipliers. One or more candidate configurations for the LPF section (29) may be generated, based on predetermined frequency rejection requirements, using a random process, e.g. a genetic algorithm. The LPF section (29) is then configured according to a selected candidate configuration and the compensator (30) configured to compensate for a pass band droop of the LPF section (29) so that the component (28) meets overall frequency rejection and group delay requirements. The division of the component (28) into two sections (29, 30) permits its configuration to be determined more quickly and in a manner that is less computationally intensive than in the prior art. By providing shift registers (36) in place of multipliers, the gate count of the component (28) and, therefore, its physical size, may be reduced.

## Description

The invention relates to a signal processing component for a digital radio receiver that is particularly suitable for, but not limited to use in, digital radio receivers for communication devices with limited physical dimensions and/or subject to cost constraints, such as mobile telephone handsets.

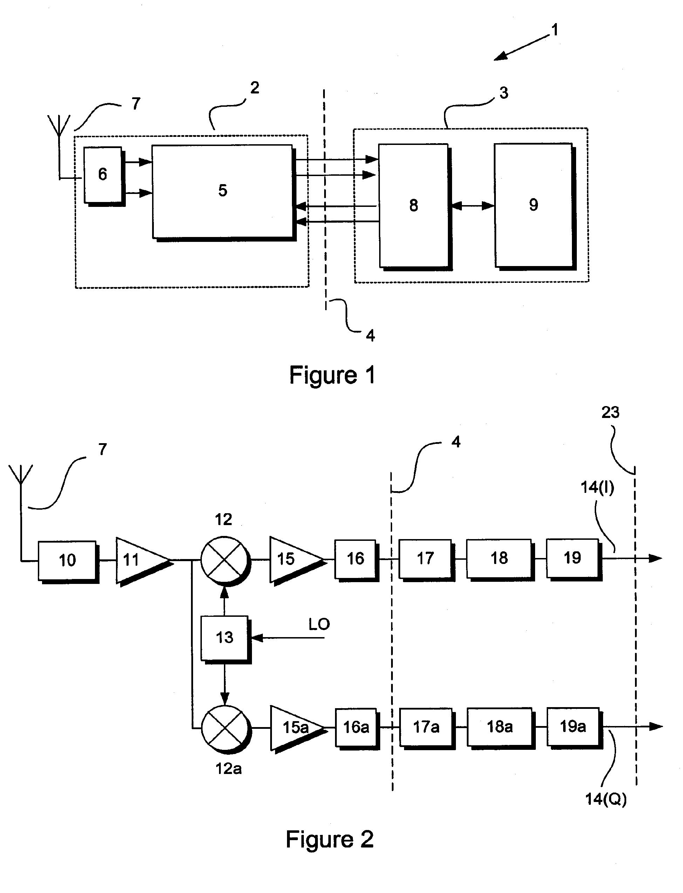

Figure 1 is a block diagram of a prior digital radio communication device 1, such as a mobile telephone. The device 1 comprises two subsystems: a radio portion 2 and a baseband portion 3, which communicate via an analogue interface 4. The radio portion 2 includes a radio transceiver integrated circuit (IC) 5, a front end module 6 through which data is to be transmitted by, or data received by, antenna 7 is passed. The baseband portion 3 comprises an analogue baseband processor 8 and a digital baseband processor 9.

Figure 2 depicts a receiver section within the communication device 1 of Figure 1. A pre-selection band pass filter 10 passes signals received by the antenna 7 that have a frequency within a desired frequency band. A low noise radio frequency amplifier 11 amplifies these signals. The signal is split into two branches and input to mixers 12, 12a which downconvert the signal using quadrature related oscillator signals from a signal generator 13. The received signal is converted directly to in-phase and quadrature signals 14(I), 14(Q) at a low frequency, close to DC, in a direct conversion receiver, or at a low intermediate frequency of a few hundred kilohertz, in a low intermediate frequency receiver, depending on the frequency LO input to the signal generator 13.

Each downconverted signal 14(I), 14(Q) is amplified by an analogue baseband amplification stage 15, 15a and passed through a low pass filter 16, 16a, in order to reduce in-band interference before its conversion into a digital signal by an oversampling analogue-to-digital converter (ADC) 17, 17a. A decimation stage 18, 18a reduces the sampling rate of the over-sampled digital signals 14(I), 14(Q) while preserving the signal information. Each digital signal 14(I), 14(Q) is then passed through a channel filter 19, 19a, which removes further unwanted interference, before being demodulated.

An example of a similar receiver section is shown in Figure 1 of WO 00/55977.

In the communication device 1 of Figures 1 and 2, the band pass filter 10, low noise amplifier 11, mixers 12, 12a, signal generator 13, baseband amplifiers 15, 15a and low pass filters 16, 16a are provided in the radio portion 2. The analogue to digital converters 17, 17a, decimation stages 18, 18a and channel filters 19, 19a are provided in the baseband portion 3.

While the receiver section of Figure 2 may be provided in a mobile telephone according to the GSM standard, many digital radio receivers configured for other applications share some, if not all, of its features.

Recent technological developments have resulted in changes to the receiver section of Figure 2 as follows.

Firstly, ADCs with increased dynamic range have become available. This permits a reduction in the gain of the analogue baseband amplification stages 15, 15a and in the filtering requirements for the low pass filters 16, 16a, although the filters 16, 16a are still required to provide anti-alias filtering.

In addition, there is a trend towards providing in the radio transceiver IC 5 functionality that has previously been provided in the baseband processor 8 or in a separate mixed signal IC. This is due, in part, to the desirability of incorporating new applications, such as reception of video signals, into communication devices. Therefore, the decimation stage 18, 18a and, optionally, some or all of the channel filtering functionality may now be provided on the radio transceiver IC 5. Furthermore, if the receiver section is intended to handle signals with a low data rate, it is preferable for the digital filtering and sample rate conversion to be carried out in the radio portion 2.

However, there are a number of factors constraining the design of the radio transceiver IC. In particular, communication devices such as mobile radio receiving devices may be limited in terms of their physical dimensions. Radio frequency and mixed signal silicon processes have tended to require a greater number of gates when compared with equivalent digital baseband processes. Therefore, if the decimation stages 18, 18a and channel filters 19, 19a are provided in the radio transceiver IC 5, the resulting circuits are likely to have a larger gate count and, therefore, a greater physical size when compared with equivalent circuits 18, 18a, 19, 19a when provided in the baseband portion 3.

The decimation stages 18, 18a and channel filters 19, 19a may be similar in configuration to low conventional digital pass filters. Such filters fall into one of two categories, finite impulse response (FIR) filters and infinite impulse response (IIR) filters. FIR filters benefit from linear phase. IIR filters generally require fewer gates than FIR filters but suffer from group delay ripple and are also more difficult to design for stability.

Both FIR and IIR filters comprise digital multipliers, which require a large number of gates. FIR and IIR filters also require the storage of large bit width digital constants, which further increase their respective gate counts. For example, a channel filter with a 1 dB pass bandwidth of 135 kHz and 45 dB or attenuation at 400 kHz and a sample frequency of 3.25 MHz requires an 11-section FIR filter. If the coefficient for each section has a length of 8 bits, then three 9 bit multipliers must be provided, requiring 11,300 gates.

The same filter specification can be implemented with a fifth order 3-section Butterworth IIR filter, where each section comprises second order sections. In this case, the coefficient width is wider than in the equivalent FIR filter for reasons of stability. The output of the IIR filter suffers from a group delay ripple of approximately 2.3 µs, making the filter unsuitable for GSM applications. In order to reduce the group delay ripple to 1.4 µs, in order to meet the GSM specification, an eighth order Butterworth filter would be required. The gate count of such a filter is likely to be similar to that of the equivalent FIR filter.

One method of reducing the gate count for a given filter specification is to configure a FIR filter in which the multiplication coefficients used are powers of two, in other words, 2^{*N*} where *N* is an integer. This removes the need for digital multipliers as any multiplication can be effected by shifting a series of bits according to the desired power of two coefficient. Such a filter is disclosed in "Evolutionary Design and FPGA Implementation of Digital Filters" by Azzini et al., in "VLSI Circuits and Systems", Proceedings of SPIE, vol. 5117, pages 485 to 496, May 2003, Maspalomas (Gran Canaria), Spain. Azzini et al. describe the use of a genetic algorithm for determining optimal coefficient values in order to configure a single FIR structure that is capable of meeting target response requirements using only power of two coefficients. Their algorithm is run on several computers, making this method is a lengthy and computationally intensive process.

According to a first aspect of the invention, a method of manufacturing a signal processing component for a digital receiver comprises providing a low pass filter section comprising a plurality of shifter circuits and configured according to predetermined frequency rejection requirements, the low pass filter section having a pass band droop and providing a compensator configured to compensate for said pass band droop.

The method results in a signal processing component with two sections, the low pass filter section and the compensator, where the combination of the two sections meets overall low pass rejection requirements. By separating the component into two sections, the determination of the configuration of the component may be performed more quickly in a manner that is less computationally intensive than in the prior method of Azzini et al. In addition, in a case where the signal processing component uses shifter circuits in place of multipliers, this division may result in a reduced gate count and, therefore, a component of reduced physical size.

The filter coefficients may be determined by generating one or more candidate filter configurations using an essentially random process using, for example, a simple random search or a genetic algorithm, and selecting a candidate filter configuration.

The candidate configurations may comprise sets of coefficients to be applied to one or more of the shifter circuits to effect a multiplication, each coefficient in each set being equal to 2^{*N*}, where *N* is an integer. *N* may be a positive integer or a negative integer.

The selection of a candidate filter configuration may be based on factors such as predicted frequency rejection characteristics and/or the number of shifter circuits required.

The compensator may configured so that a combination of the low pass filter section and compensator meets overall frequency rejection and group delay performance requirements. The compensator may also comprise a plurality of shifter circuits and be configured so that a second set of coefficients may be applied to the shifter circuits in order to effect a multiplication, each coefficient in the second set being equal to 2^{*M*}, where *M* is an integer. *M* may be a positive or a negative integer.

This aspect also provides a digital filter and a decimation stage manufactured by this method.

According to a second aspect of the invention, a signal processing component for a digital receiver comprises a low pass filter section comprising a plurality of shifter circuits, configured so that a set of coefficients may be applied to said shifter circuits in order to effect a multiplication, each coefficient in the set being equal to 2^{*N*}, where *N* is a positive or negative integer, the low pass filter section having a pass band droop, and a compensator configured to compensate for said pass band droop.

The compensator may comprise a second plurality of shifter circuits, configured so that a second set of coefficients may be applied to said second plurality of shifter circuits in order to effect a multiplication, each coefficient in the second set being equal to 2^{*M*}, where *M* is a positive or negative integer.

This configuration may be used to provide various signal processing components. For example, the signal processing component may be a filter configured to filter an input signal or a decimation stage configured to convert a sampling rate of the input signal.

This aspect also provides a digital receiver comprising said signal processing component, and a communication device, for example, a mobile telephone, comprising such a digital receiver. The signal processing component may be located in a radio portion of the digital receiver.

Embodiments of the invention will now be described with reference to the accompanying drawings, in which:
Figure 1 is a block diagram of a prior digital radio communication device;
Figure 2 depicts a receiver section that shows how the components of the receiver section are divided between a radio and a baseband portion in the communication device of Figure 1 and in a communication device according to the present invention;
Figure 3 is a block diagram of a digital radio communication device according to the present invention;
Figure 4 depicts a configuration of an example of a filter for use in the communication device of Figure 3;
Figure 5 depicts a multiplierless low pass filter section in the filter of Figure 4;
Figure 6 is a graph of the frequency response of a stage within the low pass filter section in the filter of Figure 4;
Figure 7 is a graph of the frequency response of a compensator within the filter of Figure 4;
Figure 8 is a graph of the frequency response of the filter of Figure 4;
Figure 9 is an enlarged view of a frequency band in the graph of Figure 8;
Figure 10 is a graph of the group delay characteristics of the filter of Figure 4; and
Figure 11 is a flowchart of a method for manufacturing the filter of Figure 4.

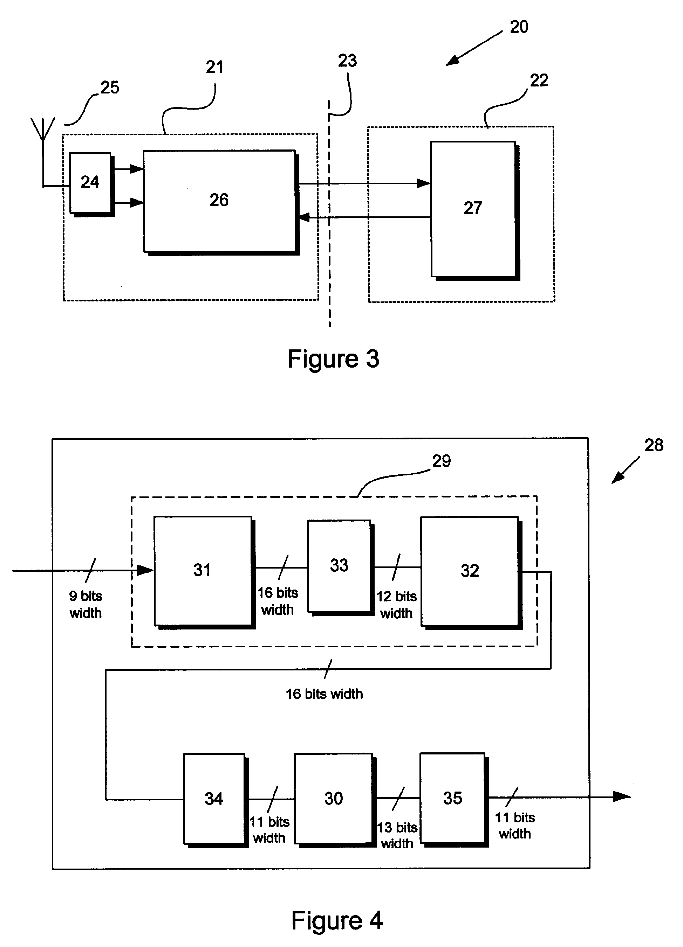

Figure 3 depicts a communication device 20, such as a mobile telephone handset, which comprises a radio portion 21 and a baseband portion 22. The radio portion 21 and baseband portion 22 can communicate with each other via a digital interface 23. The radio portion 21 comprises a front end module 24 for transmitting and receiving signals via an antenna 25. A radio transceiver IC 26 and baseband processor 27 are provided for processing the received signals.

A receiver section comprising equivalent components to those shown in Figure 2 is provided. However, a sample rate conversion stage and channel filter, equivalent to circuits 18, 18a, 19 and 19a in Figure 2, are provided in the radio portion 21 and not the baseband portion 22.

In this particular embodiment, the low pass filter, decimation stage and channel filter share a similar configuration. This configuration is shown in Figure 4, where a component, in this example, a multiplier-free low pass filter 28, comprises a low pass filter section 29 and a high pass compensator 30, arranged to compensate for a pass band droop of the low pass filter section 29. The two sections 29, 30 are configured so that the filter 28 meets overall low pass band rejection requirements.

The two-section configuration shown Figure 4 has a number of advantages over a unified structure. Firstly, it results in a more efficient design process with greater flexibility. For example, changes in the specification of the component, such as amended frequency rejection requirements, can be implemented without lengthy simulations or optimisation procedures. Secondly, this configuration is likely to have a lower gate count than unified arrangements and, therefore, have a smaller physical size.

The configuration will now be described by way of example. An example low pass filter section 29 comprises two binary value low pass FIR filters 31, 32, which provide a gain of 30 dB and remove all signals with a frequency exceeding 400 kHz. Each low pass FIR filter 31, 32 has ten power-of-two multiplication stages, which are provided by shift registers. A binary value gain selector 33 is located between the two low pass FIR filters 31, 32. The binary value gain selector shifts an input signal by a predetermined number of bits and, if required, inverts the sign of the input signal. In this example, the binary value gain selector shifts the input signal by 16 bits.

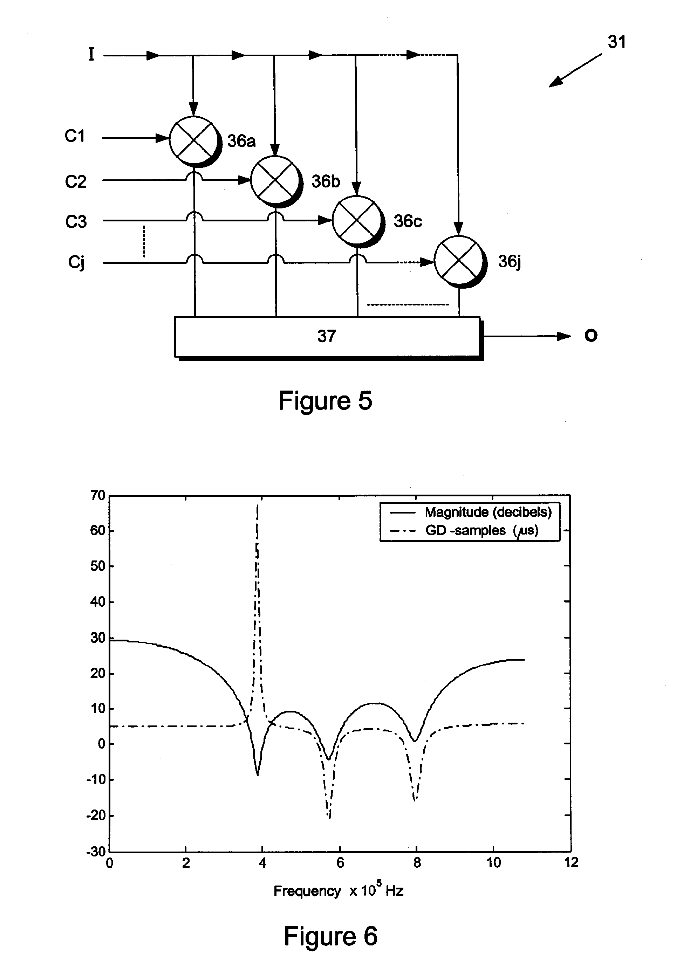

Figure 5 depicts the low pass filter 31 in more detail. In this embodiment, the low pass filter section 29 is arranged so that all multiplication steps are performed using power of two coefficients. Therefore, instead of using multipliers, as in a normal FIR, the multiplication steps are performed using a plurality of shift registers 36a to 36j, which shift bits of an input signal I by a predetermined number of bits C1 to Cj, according to the desired multiplication coefficient. The values output by the shift registers 36a to 36j are summed by an adder 37 to produce an output signal O. The use of shift registers 36a to 36j in place of multipliers results in a reduced gate count. The frequency response of the low pass filter is shown in Figure 6.

In this example, two further binary value gain selectors 34, 35 are provided on either side of the compensator 30, as shown in Figure 4. The further binary gain selectors 34 and 35 are also shift registers and here are arranged to shift the input signal by 32 bits and 4 bits respectively.

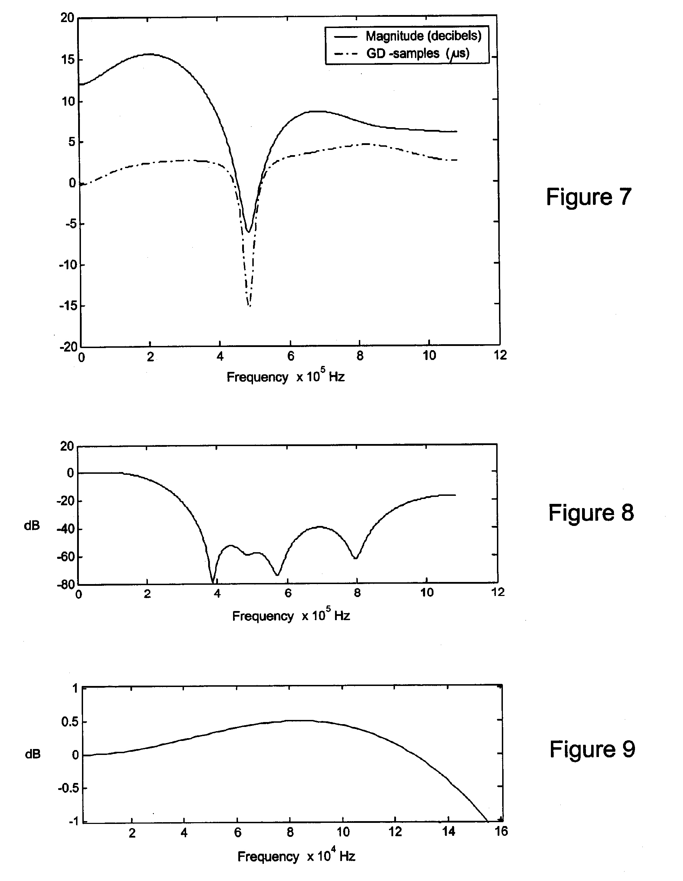

In this particular example, the compensator 30 has a similar configuration to the low pass filter 29 shown in Figure 5, comprising seven power-of-two multiplication stages and is arranged to provide a gain of 12 dB. The frequency response of the compensator 30 is shown in Figure 7.

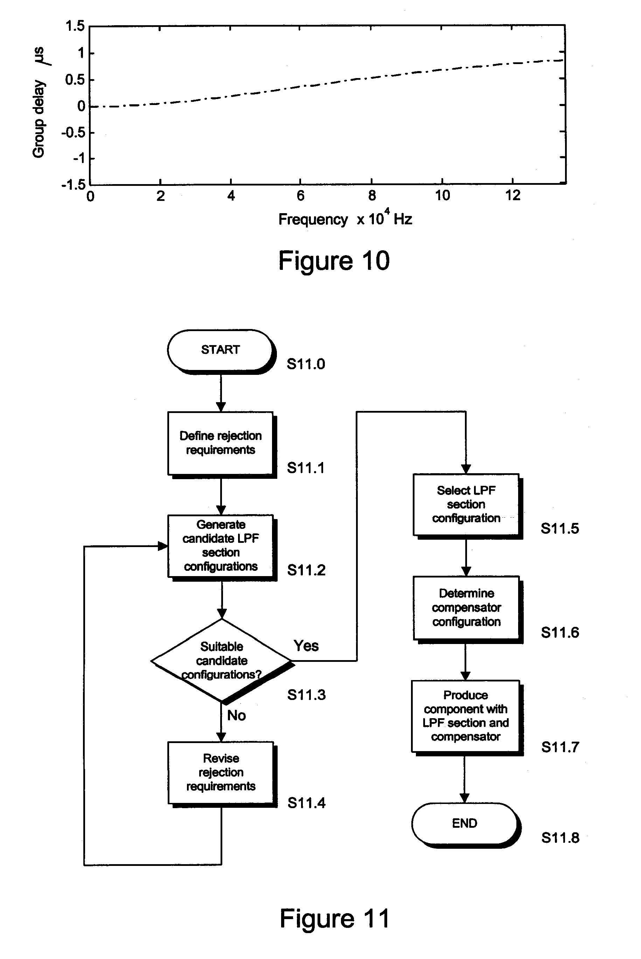

The overall frequency response of the filter 28 is shown in Figure 8. Figure 9 provides an enlarged view of this graph with respect to a particular frequency band of 0 to 160 kHz. The overall group delay characteristic of the filter 28 is shown in Figure 10.

As the configuration of Figure 4 does not include any multipliers, gates are required only for the shift registers 36a to 36j, the adder 38 and the equivalent components of the compensator 30. In this example, binary gain shifts are implemented between the low pass filter and compensation sections 29, 30 to further reduce the gate count. In addition, inter-stage gain reduction can be used to reduce word width, for example, using a gain selector 33. This allows the gate count to be decreased further.

In this particular example, the gate count of the filter 28 is approximately 5000 gates. This represents a 55% reduction in gate count when compared to a conventional FIR solution.

A procedure for manufacturing a component, such as a low pass filter, channel filter or decimation stage with a two-section configuration will now be described, with reference to the flowchart of Figure 11.

Starting at step s11.0, a set of frequency rejection requirements for the low pass filter section 29 is defined (step s11.1). The frequency rejection requirements may be defined loosely at this stage as, once the configuration of the low pass filter 29 is determined, the compensator 30 can be configured so that the required overall frequency rejection of the component 28 is obtained.

Candidate configurations for the low pass filter section 29 are then generated (step s11.2). The candidate configurations may vary between one another in terms of the number of multiplication stages, that is, shift registers 36a-36j, and in the power-of-two coefficients used at each stage 36. The candidate configurations can be randomly generated using a genetic algorithm. The genetic algorithm may be more efficient, that is, less computer intensive and/or quicker to run, than the prior genetic algorithm of Azzini et al. This is because the genetic algorithm is used to optimise the design of only one part of the component 28, that is, the low pass filter section 29, rather than attempting to obtain the required frequency rejection using an optimised unified structure.

If no suitable candidate configurations are generated (step s11.3), for example, if the candidate configurations are too complex or large for an intended application, the frequency rejection requirements can be revised (step s11.4) and new candidate configurations generated (step 11.2).

Having generated one or more suitable candidate configurations (step s11.3), the most suitable configuration is selected (step s11.5). The selection may be made on criteria such as how well the low pass filter section 29 meets more precisely defined frequency rejection requirements and/or group delay requirements. Alternatively, or additionally, the selection may be based on other factors such as its gate count.

With the characteristics of the low pass filter section 29 determined, the compensator 30 can then be designed to meet the overall frequency rejection and group delay performance requirements for the component 28 (step s11.6).

The component 28 can then be produced with an appropriate combination of a low pass filter section 29 and compensator 30 (step s11.7). The component 28 may further include gain selectors 34, 35 if required. This concludes the procedure (step s11.8).

Although the invention has been described with reference to a filter 28 or decimation stage located in the radio portion 21 of a communication device 20, the same two-section configuration and manufacturing method can be used to produce filters or decimation stages for use in a baseband portion 22.

In addition, the invention is not limited to components for mobile telephone handsets. The components 28 may be used in other types of communication device. However, the reduction in gate count and, therefore, physical size, of the component 28 make this type of configuration particularly suitable for components of a mobile telephone handset and other devices that have limited physical dimensions and/or are subject to cost constraints.

It is not necessary for each of the low pass filter, channel filter and decimation stage of the receiver section of the communication device 20 to be designed with the two-part configuration of Figure 4. It should also be noted that in some applications, depending on the overall design of the receiver section, it may be possible to omit the low pass filters and baseband amplifiers, equivalent to the amplifiers 16, 16a and filters 15a, 15b in Figure 2, altogether.

## Claims

1. A method of manufacturing a signal processing component (28) for a digital receiver, the method comprising:
providing a low pass filter section (29) comprising a plurality of shifter circuits (36) configured according to predetermined frequency rejection requirements, the low pass filter section having a pass band droop; and
providing a compensator (30) configured to compensate for said pass band droop.

2. A method according to claim 1, wherein the step of providing a low pass filter section (29) comprises producing one or more candidate configurations (s11.2) according to said predetermined frequency rejection requirements, selecting one of said candidate configurations (s11.5) and configuring said low pass filter section accordingly (s11.7).

3. A method according to claim 2, wherein said step of producing one or more candidate configurations (s11.2) comprises generating candidate configurations using an essentially random process.

4. A method according to claim 3, wherein said step of producing one or more candidate configurations (s11.2) is performed using a genetic algorithm.

5. A method according to claim 2, 3 or 4, wherein said candidate configurations comprise sets of coefficients to be applied to one or more of the shifter circuits (36) to effect a multiplication, each coefficient in each set being equal to *2*^{*N*}*,* where *N* is an integer.

6. A method according to any one of claims 2 to 5, wherein said selection (s11.5) is based on a predicted frequency rejection characteristic of low pass filter sections (29) configured according to said candidate configurations.

7. A method according to any one of claims 2 to 6, wherein said selection (s11.5) is based on a predicted number of shifter circuits (36) required by a low pass filter section (29) configured according to said candidate sets of coefficients.

8. A method according to any one of the preceding claims, wherein the compensator (30) is configured so that a combination of the low pass filter section (29) and compensator meets overall frequency rejection and group delay performance requirements.

9. A method according to claim 8, wherein said compensator (30) comprises a second plurality of shifter circuits and is configured so that a second set of coefficients may be applied to said second plurality of shifter circuits in order to effect a multiplication, each coefficient in the second set being equal to 2^{*M*}, where *M* is an integer.

10. A digital filter (28) manufactured by a method according to any one of the preceding claims.

11. A decimation stage manufactured by a method according to any one of the preceding claims.

12. A signal processing component (28) for a digital receiver comprising:
a low pass filter section (29) comprising a plurality of shifter circuits (36), configured so that a set of coefficients may be applied to said shifter circuits in order to effect a multiplication, each coefficient in the set being equal to 2^{*N*}, where *N* is an integer, the low pass filter section having a pass band droop; and
a compensator (30) configured to compensate for said pass band droop.

13. A signal processing component (28) according to claim 13, wherein said compensator (30) comprises a second plurality of shifter circuits, configured so that a second set of coefficients may be applied to said second plurality of shifter circuits in order to effect a multiplication, each coefficient in the second set being equal to 2^{*M*}, where *M* is an integer.

14. A signal processing component (28) according to claim 12 or 13, configured to filter an input signal (I).

15. A signal processing component (28) according to claim 12 or 13, configured to convert a sampling rate of an input signal.

16. A digital receiver (24, 26, 27) comprising a signal processing component (28) according to any one of claims 12 to 15.

17. A digital receiver (24, 26, 27) according to claim 16, comprising a radio portion (21) and a baseband portion (22), wherein the signal processing component (28) is located within said radio portion (21).

18. A communication device (20) comprising a digital receiver (24, 26, 27) according to claim 16 or 17.

19. A mobile telephone (20) comprising a digital receiver (24, 26, 27) according to claim 16 or 17.
